# EUROPÄISCHE PATENTSCHRIFT

(11) **EP 2 942 811 B1**
(45) Veröffentlichungstag und Bekanntmachung des Hinweises auf die Patenterteilung: **27.11.2019**
(21) Anmeldenummer: 15160326.3
(22) Anmeldetag: 23.03.2015
(51) Int. Cl.: H01L 23/62, H01L 23/48, H01H 79/00, H02H 3/02, H01H 3/00, H01L 23/00

(54) **KURZSCHLUSSVORRICHTUNG ZUM AUTOMATISCHEN KURZSCHLIEßEN EINES TRANSISTORS UND VERFAHREN ZU EINEM SOLCHEN KURZSCHLIEßEN**
SHORT-CIRCUIT DEVICE FOR AUTOMATICALLY SHORT CIRCUITING A TRANSISTOR AND METHOD FOR SUCH SHORT-CIRCUITING
DISPOSITIF DE COURT-CIRCUITAGE AUTOMATIQUE D'UN TRANSISTOR ET PROCÉDÉ D'UN TEL COURT-CIRCUIT

(30) Priorität: 15.04.2014 DE 102014207174
(43) Veröffentlichungstag der Anmeldung: 11.11.2015
(73) Patentinhaber: Siemens Aktiengesellschaft, 80333 München (DE)
(72) Erfinder: Mitic, Gerhard, 81827 München (DE); Stegmeier, Stefan, 81541 München (DE); Weidner, Karl, 81245 München (DE); Sahan, Benjamin, 90762 Fürth (DE); Schremmer, Frank, 90768 Fürth (DE)

(56) Entgegenhaltungen:
- EP-A1- 2 544 229
- US-A1- 2013 062 178

## Beschreibung

Die Erfindung betrifft eine Kurzschlussvorrichtung zum automatischen Kurzschließen eines ersten Elements eines Transistors mit einem zweiten Element des Transistors in einem thermischen Fehlerfall des Transistors gemäß dem Oberbegriff von Patentanspruch 1. Sie betrifft ferner ein Verfahren zum Betreiben einer solchen Kurzschlussvorrichtung.

Das Umfeld der vorliegenden Erfindung betrifft die Sicherstellung einer leistungselektronischen Energiewandlung und eines leistungselektronischen Energietransportes, wie er beispielsweise im Bereich von Hochleistungsantrieben mit insbesondere mehr als 20 MW Leistung oder bei der Hochspannungs-Gleichstrom-Übertragung eine Rolle spielt. Die Hochspannungs-Gleichstrom-Übertragung (HGÜ) ist eine Technik für den verlustarmen Energietransport und somit ein Schlüssel für eine stärkere Einbindung erneuerbarer Energiequellen in ein Stromnetz. Heute kommen hier meist leistungselektronische Bauteile in Form von Thyristoren oder auch Bipolartransistoren mit isolierter Gate-Elektrode (IGBT) zum Einsatz. Nach einem Fehler, beispielsweise einem Abschaltversager oder einem thermischen Fehlerfall, sind die IGBTs jedoch nicht sicher elektrisch leitfähig. Meist sind in industriellen IGBT-Modulen die Transistorchips mit Bonddrähten kontaktiert. Die BonddrahtTechnologie ist als Ausfallmechanismus jedoch insbesondere bei der Reihenschaltung von IGBTs, sowie in ähnlichen Abwandlungen wie sie beispielsweise einem modularen Multilevelumrichter vorkommen, problematisch. Im Fehlerfall kommt es außerdem beim Ablösen des Bonddrahtes zum Zünden eines Lichtbogens und in Folge ggf. zu einem Kollateralschaden in der Umgebung des IGBTs. Zur Vermeidung der Kollateralschäden im Augenblick des Transistorausfalls wird ein hoher Aufwand für eine Qualifizierung der IGBT-Module für solche Szenarien und für die Fertigung eines dann meist erforderlichen zusätzlichen Gehäuses betrieben.

Die DE 10 2008 059 670 B3 offenbart einen mechanischen Kurzschließer, welcher mit dem Transistor parallel geschaltet wird, um in einem Fehlerfall einen IGBT-Umrichter weiter betreiben zu können. Die EP 098 9611 B1 offenbart eine Alternative auf Halbleiterebene, bei welcher eine Silberschicht auf einen IGBT aufgetragen wird, die im Kurzschlussfall des Transistors eine leitfähige Legierung zwischen dem im Chip vorhandenen Silizium und dem Silber bildet.

Die EP 2 544 229 A1 offenbart eine Technologie mit modulinternen Federkontakten, bei welchen sich oberhalb eines Transistorchips ein bei niedrigen Temperaturen schmelzendes Material befindet, welches in einem thermischen Fehlerfall schmilzt und durch den Federkontakt verdrängt wird, um einen elektrischen Druckkontakt zu schließen.

Aus der US 2013/0062178 A1 ist ein Druckschalter bekannt, bei dem eine äußere Kontakthülle innenseitig zwei flächige Kontaktelemente aufweist, die von einem inneren Leiter isoliert sind. Die Isolation ist dabei aus einem elastischen Material gefertigt und weist Löcher auf, sodass bei einem von außen auf die Kontakthülle ausgeübten Druck ein elektrischer Kontakt zwischen einem Kontaktelement und dem inneren Leiter herstellbar ist.

Es ist eine Aufgabe der vorliegenden Erfindung, eine Kurzschlussvorrichtung zum automatischen Kurzschließen eines Transistors bzw. ein Verfahren zum Kurzschließen eines Transistors bereitzustellen, welche bzw. welches einen einfachen Aufbau aufweist bzw. ermöglicht und somit bei zuverlässiger Funktionsweise räumlich kompakt ausgeführt werden kann und dabei möglichst unempfindlich gegenüber Erschütterungen und anderen von außen einwirkenden Kräften ist.

Diese Aufgabe wird von einer Kurzschlussvorrichtung und einem Verfahren zum Betreiben einer Kurzschlussvorrichtung gemäß den unabhängigen Patentansprüchen gelöst. Vorteilhafte Ausführungsformen ergeben sich aus den abhängigen Ansprüchen, der Beschreibung und den Figuren.

Eine erfindungsgemäße Kurzschlussvorrichtung zum automatischen Kurzschließen eines ersten Elements eines Transistors mit einem zweiten Element des Transistors in einem thermischen Fehlerfall des Transistors umfasst drei Komponenten: Eine erste Kurzschlussfläche, welche mit dem ersten Element elektrisch gekoppelt ist, eine zweite Kurzschlussfläche, welche mit dem zweiten Element elektrisch gekoppelt ist und eine Isolationsschicht zwischen den beiden Kurzschlussflächen. Dabei sind die beiden Kurzschlussflächen in einem Normalbetrieb des Transistors vor dem Fehlerfall elektrisch voneinander isoliert, und in einem auf den Fehlerfall folgenden Kurzschlussbetrieb des Transistors elektrisch kurzgeschlossen. Unter anderem hat eine der beiden Kurzschlussflächen eine Oberflächenstruktur, welche zumindest eine Ausformung nach Art eines Durchstoßkörpers aufweist, um eine Durchstoßarbeit zu verringern, welche erforderlich ist, um bei einem Annähern der beiden Kurzschlussflächen im Fehlerfall die Isolationsschicht zu durchstoßen und die beiden Kurzschlussflächen elektrisch kurzzuschließen. Insbesondere ist die Oberflächenstruktur also derart geformt, dass eine im Verhältnis zur Größe der Kurzschlussfläche geringe Querschnittsfläche die Isolationsschicht durchstoßen muss, um den elektrischen Kontakt zwischen den Kurzschlussflächen herzustellen.

Um die Kurzschlussvorrichtung besonders robust, kompakt und zuverlässig zu gestalten, sind in dem Normalbetrieb des Transistors die beiden Kurzschlussflächen und die Isolationsschicht druckfrei aneinander gehalten. Es wirken also lediglich globale Kräfte, wie beispielsweise eine Schwerkraft, gleichmäßig auf die verschiedenen Komponenten der Kurzschlussvorrichtung ein, und lokale Kräfte, welche beispielweise unmittelbar lediglich auf eine oder mehrere bestimmte Komponenten oder bestimmte Teilbereiche dieser Komponenten wirken, wie beispielsweise eine vorgespannte Feder welche auf eine der Kurzschlussflächen drückt oder dergleichen, liegen nicht vor.

Im Normalbetrieb wirken also keine Druckkräfte eines zusätzlichen Mechanismus mit weiteren, vorliegend nicht beschriebenen Bauteilen, auf die Kurzschlussvorrichtung ein. Die Komponenten der Kurzschlussvorrichtung sind hier darauf ausgelegt, dass erst im thermischen Fehlerfall des Transistors durch eine Hitzeentwicklung die beiden Kurzschlussflächen gegeneinander drückbar sind. "Drückbar" ist hier insbesondere im Sinne von "drückbar und bewegbar" zu verstehen. Erst durch die in dem thermischen Fehlerfall auftretende Hitzeentwicklung entsteht also ein Druck auf zumindest eine der beiden Kurzschlussflächen, und dadurch dass die beiden Kurzschlussflächen durch die Hitzeentwicklung gegeneinander drückbar sind, sind sie auch zueinander bewegbar, bzw. aneinander annäherbar. Der thermische Fehlerfall zieht also eine Hitzeentwicklung nach sich, welche in einen Druck mündet, welcher ein Annähern der beiden Kurzschlussflächen aneinander und schließlich einen elektrischen Kontakt der beiden Kurzschlussflächen nach sich zieht. Bei dem thermischen Fehlerfall handelt es sich insbesondere um eine starke Ausdehnung oder eine Explosion bzw. teilweise Verdampfung in dem Transistor, beispielsweise in einem Transistorchip. Dieser Fehlerfall ist dabei insbesondere durch lokale Temperaturspitzen von mehr als 1000°C gekennzeichnet. Im Normalbetrieb beträgt die Temperatur des Transistors insbesondere unter 300°C, insbesondere zwischen 100°C und 200°C. Bei einem Fehlerfall kann also insbesondere von einer Steigerung der Temperatur im Transistor von einer Größenordnung ausgegangen werden.

Die Erfindung hat also den Vorteil, dass ein dauerhafter Kontakt zwischen dem ersten und dem zweiten Element des Transistors, insbesondere zwischen Emitter und Kollektor, geschlossen werden kann. Dabei entfällt ein mechanisches Schließen eines Kontaktes durch einen zusätzlichen Mechanismus, so dass die Zuverlässigkeit und Sicherheit der Kontaktierung gesteigert wird und außerdem der erforderliche Bauraum verringert wird, da beispielsweise auch kein zusätzliches Gehäuse erforderlich ist. Auch entfällt eine mechanische zusätzliche Belastung der Bauteile im Normalbetrieb, da die Kurzschlussvorrichtung im Normalbetrieb druckfrei aufgebaut ist. Die Kurzschlussvorrichtung ist somit besonders robust und mechanisch stabil, also insbesondere resistent gegenüber Erschütterungen, wie sie im Normalbetrieb in vielen Einsatzbereichen oder bei einem Transport oftmals vorkommen. Da die Kurzschlussvorrichtung lediglich Komponenten erfordert, wie sie in einem Transistor üblicherweise vorliegen, also insbesondere leitende und nichtleitende Schichten, kann ihre Herstellung bzw. die Herstellung eines Transistors mit einer solchen Kurzschlussvorrichtung auch kostengünstig in bereits bestehende Produktionslinien von Transistoren und/oder Transistormodulen integriert werden.

Die Oberflächenstruktur zum Durchstoßen der Isolationsschicht kann hier durch verschiedene Prozesse aufgebaut worden sein, insbesondere durch eine physikalische Gasphasenabscheidung und/oder Galvanik und/oder Trockenätzprozesse bzw. Nassätzprozesse von bereits vorhandenen Metallisierungen, und/oder durch thermische Metallspritzverfahren, wie beispielsweise Kupferspray, und/oder durch mechanische Cuttingverfahren und/oder ähnliche Verfahren. Die Oberflächenstruktur umfasst hier bevorzugt Metalle, insbesondere Kupfer und/oder Zinn und/oder Aluminium und/oder Nickel, metallische Verbindungen, insbesondere Lote, und Halbleiter, insbesondere dotiertes Silizium. Die Oberflächenstruktur hat den Vorteil, dass die Isolationsschicht leichter, also mit einem geringeren Kraft- oder Druckaufwand durchdrungen werden kann. Außerdem kann so das Material der Isolationsschicht wesentlich freier gewählt werden. Es wird also die Zuverlässigkeit der Kurzschlussvorrichtung erhöht und es können ggf. mehr Materialien für die Isolationsschicht in Betracht gezogen werden.

Insbesondere kann hier vorgesehen sein, dass die zumindest eine Ausformung die Form einer Säule oder einer Pyramide oder einer Kugel, insbesondere einer Halbkugel, hat. In den ersten beiden Fällen kann hier insbesondere eine abgerundete Spitze vorgesehen sein. Es ist die Form der Spitze, welche von der Oberfläche weg weist und im Fehlerfall die Isolationsschicht durchbricht, insbesondere derart gewählt, dass eine elektrische Spitzenentladung vermieden wird. Dies kann beispielsweise über Mindestkrümmungsradien der Spitze von insbesondere mehr als 10⁻⁵ m, insbesondere mehr als 10⁻⁴ m und bevorzugt mehr als 10⁻³ m erfolgen, da diese elektrische Feldstärken von weniger als 100 kV/mm verursachen. Diese Feldstärke kann bei geeigneter Wahl des Materials der Isolationsschicht noch zu keinem unerwünschten elektrischen Durchschlag führen. Diese Formen der Ausformung haben den Vorteil, dass sie leicht herstellbar sind und, wenn auf der Kontaktfläche eine Vielzahl dieser Ausformungen nebeneinander besteht, eine gute und sichere elektrische Verbindung der beiden Kontaktflächen ermöglichen.

In einer vorteilhaften Ausführungsform ist vorgesehen, dass die zumindest eine Ausformung zumindest teilweise aus einem ersten Material und die andere Kurzschlussfläche, welche nicht über die zumindest eine Ausformung verfügt, zumindest teilweise aus einem zweiten Material gebildet ist, und das erste Material mit dem zweiten Material eine eutektische Legierung bildet. Es bilden also insbesondere die Materialien der sich im Fehlerfall berührenden Bereiche der beiden Kurzschlussflächen oder der zumindest einen Ausformung der einen Kurzschlussfläche und der anderen Kurzschlussfläche die eutektische Legierung. Dabei sind die Materialien der eutektischen Legierung bevorzugt so gewählt, dass die beiden Materialen an den Kontaktpunkten bei einer Temperatur schmelzen, welche oberhalb der Betriebstemperatur des Transistors liegt und/oder die erforderliche höhere Temperatur, welche zum Aufschmelzen einmal verschmolzener Kontaktstellen erforderlich ist oberhalb der Temperatur im Kurzschlussbetrieb, insbesondere oberhalb der im thermischen Fehlerfall auftretenden Temperatur ist. Das hat den Vorteil, dass besonders zuverlässige und sichere elektrische Kontakte zwischen den Kurzschlussflächen bestehen, welche nur schwer zu lösen sind. Damit bleiben auch bei einer weiteren Verformung der Kontaktflächen in dem thermischen Fehlerfall oder einer weiteren thermischen Einwirkung einmal geschlossene elektrische Kontakte erhalten.

Es kann auch vorgesehen sein, dass die erste Kurzschlussfläche ein erstes Material und die zweite Kurzschlussfläche ein zweites Material umfasst, und das erste Material mit dem zweiten Material eine eutektische Legierung bildet.

In einer weiteren Ausführungsform ist vorgesehen, dass die Isolationsschicht ein keramisches Material und/oder einen Polymer und/oder ein Siloxan und/oder eine Kombination dieser Materialien enthält, insbesondere die Isolationsschicht aus einem Material besteht, welches im Normalbetrieb des Transistors fest ist, also einen ersten Zustand einnimmt, und im thermischen Fehlerfall des Transistors erweicht und/oder seinen Aggregatszustand ändert, so dass das Isolationsmaterial entweichen kann, also einen zweiten Zustand einnimmt, in welchem das Material leichter durchstoßen werden kann, als im ersten Zustand. Das Material der Isolationsschicht ist insbesondere fest in einem Temperaturbereich von weniger als 300°C. Auch weist es, insbesondere durch einen Phasenübergang zwischen den beiden Zuständen, eine große Eindringeigenschaft auf, ist also zumindest lokal gut zu verdrängen oder zu durchstoßen. Dies kann insbesondere über einen Phasenübergang in einem Temperaturbereich oberhalb der Betriebstemperatur und unterhalb der im thermischen Fehlerfall auftretenden Temperatur, also insbesondere oberhalb von 500°C und/oder unterhalb von 1000°C erfolgen. Insbesondere ein Verdampfen des Isolationsmaterials ist hier vorteilhaft, da dann die beiden Kurzschlussflächen besonders leicht in Kontakt zueinander bringbar sind. Im Falle eines solchen, verdampfenden Isolationsmaterials kann zumindest eine der beiden Kontaktflächen und ggf. hinter den Kurzschlussflächen liegende Bauteile wie beispielweise ein Träger der K porös ausgeführt werden, so dass das dann verdampfte Isolationsmaterial entweichen kann. Das Material der Isolationsschicht, also das Isolationsmaterial, weist hier insbesondere eine elektrische Isolation von mehr als 30 kV/mm, insbesondere mehr als 100 kV/mm oder 200kV/mm auf. Die Dicke der Isolationsschicht beträgt insbesondere zwischen 10 µm und 1000 µm. Das hat den Vorteil, dass eine gute elektrische Isolation zwischen den beiden Kurzschlussflächen im Normalbetrieb gewährleistet ist und gleichzeitig über die temperaturabhängige Festigkeit, also Durchstoßbarkeit, der Isolationsschicht eine leichte Durchstoßbarkeit der Isolationsschicht im thermischen Fehlerfall gewährleistet ist.

Bei der Isolationsschicht kann es sich insbesondere um eine Folie handeln, was den Vorteil einer besonders guten Aufbringbarkeit zwischen den beiden Kurzschlussflächen mit sich bringt. Alternativ kann die Isolationsschicht auch beispielsweise in einem Druckverfahren, bspw. in einem Siebdruckverfahren, aufgebracht werden.

In einer weiteren Ausführungsform ist vorgesehen, dass hinter der einen der beiden Kurzschlussflächen, also auf der Seite der einen Kurzschlussfläche, welche der anderen Kurzschlussfläche abgewandt ist, ein Chip des Transistors, ein Transistorchip, angeordnet ist, der, insbesondere planar, mit einem Träger der einen Kurzschlussfläche ankontaktiert ist. Dabei ist hinter der einen Kurzschlussfläche, insbesondere zwischen dem Transistorchip und dem Träger, zumindest ein Ausdehnungselement angeordnet. Dieses Ausdehnungselement hat einen thermischen Ausdehnungskoeffizienten, welcher größer ist als der Ausdehnungskoeffizient von den Bauteilen, welche das des Ausdehnungselement unmittelbar umgeben, insbesondere des Trägers und/oder des Chips und/oder einer Chipisolation und/oder einem Kollektorkontakt, sodass im thermischen Fehlerfall über ein Ausdehnen des Ausdehnungselements die eine Kurzschlussfläche an die andere Kurzschlussfläche gedrückt wird.

Das Material des Ausdehnungselements kann hier auch im thermischen Fall seinen Aggregatszustand verändern. Insbesondere kann es sich um ein Material handeln, welches ab einer bestimmten Temperatur schlagartig aufschäumt, wie bspw. das Produkt "Revalpha" vom Hersteller NITTO DENKO, oder anderen Mischmaterialien, welche beispielsweise über eingeschlossene Gas- bzw. Gelkapseln verfügen, welche bei einem Erhitzen ihr Volumen vergrößern. Das hat den Vorteil, dass der Druck auf die Kurzschlussflächen im Fehlerfall erhöht wird bzw. besser verteilt werden kann. Über die Wahl des Materials der Ausdehnungselemente kann auch gezielt Einfluss auf das Ausmaß der Temperaturabhängigkeit des Kurzschließens genommen werden.

In einer bevorzugten Ausführungsform ist vorgesehen, dass eine der Kurzschlussflächen auf einem Träger angeordnet ist, welcher ein Bimetall oder eine Formgedächtnislegierung umfasst, sodass im thermischen Fehlerfall die eine Kurzschlussfläche durch ein Biegen des Trägers an die andere Kurzschlussfläche gedrückt wird. Es können also Materialien verwendet werden, welche im thermischen Fehlerfall, dem Erhitzen, eine mechanische Kraft ausüben. So kann insbesondere bei 300°C über ein Biegen zumindest einer Kurzschlussfläche ein Kurzschluss zwischen den beiden Elementen des Transistors erzielt werden.

Ist die Oberflächenstruktur zum Durchstoßen der Isolationsschicht direkt auf einer Emitter-Metallisierung des Transistors realisiert, so kann derselbe Effekt erreicht werden, indem diese Oberflächenstruktur aus einem anderen Material als die darunter liegende Emitter-Metallisierung ausgeführt wird, sodass Emitter-Metallisierung und Oberflächenstruktur sich im thermischen Fehlerfall unterschiedlich stark ausdehnen. Auch hier wird der Druck auf die Kontaktflächen im thermischen Fehlerfall erhöht. Auch kann über eine gezielte Auswahl der verwendeten Materialien Einfluss auf die Temperaturabhängigkeit des Kurzschließens genommen werden.

In einer besonders vorteilhaften Ausführungsform ist vorgesehen, dass das erste Element des Transistors ein Kollektor des Transistors und das zweite Element des Transistors ein Emitter des Transistors ist. Insbesondere kann es sich bei dem Transistor um einen Bipolartransistor mit isolierter Gate-Elektrode handeln. Es kann also besonders einfach, ohne weitere Strukturen, Kollektor und Emitter des Transistors kurzgeschlossen werden. Gerade für einen IGBT ist ein automatisches Kurzschließen in vielen Fällen wünschenswert und kann somit zuverlässig und robust erzielt werden.

Die Erfindung betrifft ferner ein Verfahren zum automatischen Kurzschließen eines ersten Elements eines Transistors mit einem zweiten Element des Transistors in einem thermischen Fehlerfall des Transistors. Der Transistor umfasst hier eine erste Kurzschlussfläche, welche mit dem ersten Element elektrisch gekoppelt ist, eine zweite Kurzschlussfläche, welche mit dem zweiten Element elektrisch gekoppelt ist, und eine Isolationsschicht zwischen den beiden Kurzschlussflächen. In einem auf dem Fehlerfall folgenden Kurzschlussbetrieb des Transistors werden die beiden Kurzschlussflächen elektrisch kurzgeschlossen. In einem Normalbetrieb des Transistors vor dem Fehlerfall werden die beiden Kurzschlussflächen und die Isolationsschicht druckfrei aneinander gehalten. Eine der beiden Kurzschlussflächen hat eine Oberflächenstruktur, welche zumindest eine Ausformung nach Art eines Durchstoßkörpers aufweist, um eine Durchstoßarbeit zu verringern, welche erforderlich ist, um bei einem Annähern der beiden Kurzschlussflächen im Fehlerfall die Isolationsschicht zu durchstoßen und die beiden Kurzschlussflächen elektrisch kurzzuschließen. Insbesondere ist die Oberflächenstruktur also derart geformt, dass eine im Verhältnis zur Größe der Kurzschlussfläche geringe Querschnittsfläche die Isolationsschicht durchstoßen muss, um den elektrischen Kontakt zwischen den Kurzschlussflächen herzustellen. Im Fehlerfall wird durch eine Hitzeentwicklung eine Kurzschlussfläche an die andere Kurzschlussfläche gedrückt, sodass die beiden Kurzschlussflächen aufgrund der Hitzeentwicklung elektrisch kurzgeschlossen werden. Die durch den thermischen Fehlerfall bedingte Hitzeentwicklung führt also über eine Volumenvergrößerung zumindest eines Bauteils, bspw. über eine Ausdehnung oder eine Explosion oder eine Verdampfung, zu einem Druckaufbau, welcher die beiden Kurzschlussflächen aneinander presst und bewegt.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie nachfolgend in der Figurenbeschreibung genannten und/oder in den Figuren alleine gezeigten Merkmale und Merkmalskombinationen sind nicht nur in der jeweiligen angegebenen Kombination, sondern auch in anderen Kombinationen oder aber in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Ausführungsbeispiele der Erfindung werden nachfolgend anhand schematischer Zeichnungen erläutert.

Es zeigen:
- FIG 1: eine schematische Schnittdarstellung eines ersten Ausführungsbeispiels einer erfindungsgemäßen Kurzschlussvorrichtung in einem Normal- und in einem Kurzschlussbetrieb;
- FIG 2: eine schematische Schnittdarstellung eines zweiten Ausführungsbeispiels einer Kurzschlussvorrichtung mit einem Emitterkontakt in einer Bondtechnologie in einem Normalbetrieb;
- FIG 3: eine schematische Schnittdarstellung eines dritten Ausführungsbeispiels mit Ausdehnungselementen hinter einer Kontaktfläche in einem Normalbetrieb; und
- FIG 4: eine schematische Schnittdarstellung eines vierten Ausführungsbeispiels mit einem Träger aus einem Bimetall für die Kontaktflächen in einem Kurzschlussbetrieb.

In den Figuren werden gleiche oder funktionsgleiche Elemente mit den gleichen Bezugszeichen versehen.

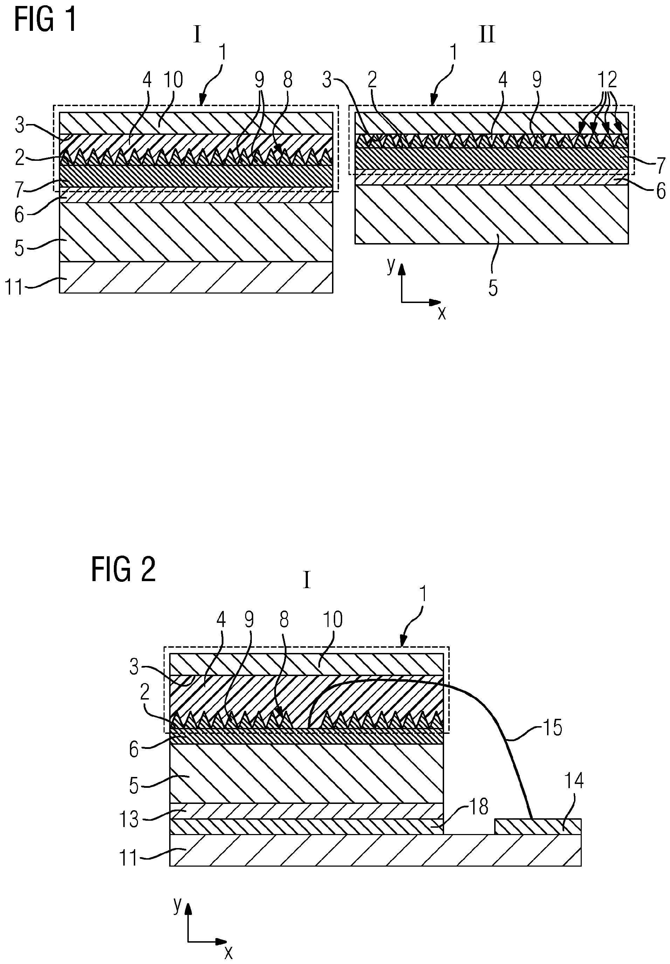

In FIG 1 ist eine schematische Schnittdarstellung eines ersten Ausführungsbeispiels einer Kurzschlussvorrichtung 1 dargestellt. Dieses Ausführungsbeispiel ist hier links, in negativer x-Richtung, in einem Normalbetrieb I, dargestellt und rechts, in positiver x-Richtung, in einem Kurzschlussbetrieb II.

In dem Normalbetrieb I ist im gezeigten Beispiel ein quaderförmiger Transistorchip 5 dargestellt, welcher auf einer Unterseite, also in negativer y-Richtung gelegenen Oberfläche, auf einem Substrat 11 angebracht ist. An einer oben liegenden, in positiver y-Richtung gelegenen Oberfläche weist der Transistorchip 5 eine Metallisierungsschicht 6 auf, welche bspw. aus Aluminium-Silizium-Kupfer (AlSiCu) besteht. Auf dieser Metallisierungsschicht 6 ist im gezeigten Beispiel ein Träger 7, der z. B. aus Kupfer besteht, aufgebracht, sodass der Transistorchip 5 mit dem Träger 7 vorliegend planar elektrisch verbunden ist. Dieser Träger 7 ist bspw. mit einem Emitter des Transistors elektrisch verbunden. Die in positiver y-Richtung gelegene Oberseite des Trägers 7 bildet hier die erste Kurzschlussfläche 2. Die erste Kurzschlussfläche 2 ist im vorliegenden Beispiel mit einer Oberflächenstruktur 8 versehen. Diese Oberflächenstruktur 8 umfasst im gezeigten Beispiel eine Vielzahl von in x-Richtung nebeneinander benachbart aneinander angeordneten, je als Pyramide ausgeformte, Ausformungen 9, deren Spitzen nach oben, also in positiver y-Richtung, weisen. Die Grundflächen der Ausformungen 9 stoßen hier aneinander an. Die Oberflächenstruktur 8 mit den pyramidenartigen Ausformungen 9 erstreckt sich in diesem Beispiel in einer Ebene, also auch in einer nicht dargestellten z-Richtung, welche sich senkrecht zur Zeichenebene erstreckt. Die Oberflächenstruktur 8 bildet also eine ebene Fläche mit vielen Spitzen, wie man sie bspw. in einer makroskopischen Größenordnung von einer Feile kennt.

Gegenüber der ersten Kontaktfläche 2 ist parallel zu dieser in positiver y-Richtung entfernt die zweite Kurzschlussfläche 3 angeordnet. Diese ist im Normalbetrieb I von den pyramidenartigen Ausformungen 9, also der Oberflächenstruktur 8, beabstandet. Zwischen der zweiten Kontaktfläche 3 und der Oberflächenstruktur 8 ist eine Isolationsschicht 4 vorhanden. Dabei handelt es sich bspw. um eine Polymerfolie mit einer elektrischen Isolation von mehr als 100 kV/mm und beispielweise einer Dicke von 1000 µm. Die zweite Kurzschlussfläche 3 wird vorliegend von einem Rahmen 10 gebildet, welcher in elektrischem Kontakt mit bspw. einem Kollektor des Transistors ist.

Vorliegend werden die Kontaktflächen also von dem mit dem Emitter des Transistors kontaktierten Träger 7 und durch den mit dem Kollektor des Transistors kontaktierten Rahmen 10 gebildet. Dabei ist die Oberflächenstruktur 8 in diesem Beispiel emitterseitig an dem Träger 7 angebracht. Alternativ kann die Oberflächenstruktur 8 mit den zugehörigen pyramidenartigen Ausformungen 9 oder sonstigen Ausformungen 9 nach Art eines Durchstoßkörpers auch auf der zweiten Kurzschlussfläche 3, also kollektorseitig an dem Rahmen 10 angebracht sein. Es ist auch möglich, die Kurzschlussvorrichtung 1 zwischen dem Transistorchip 5 und dem Substrat 11 anzuordnen. Entsprechend ist dann vorzugsweise die dem Transistorchip 5 in dieser Ausführungsform dann nähergelegene Kurzschlussfläche mit dem Kollektor des Transistorchips 5 elektrisch gekoppelt.

Tritt nun in der in FIG 1 gezeigten Ausführungsform ein thermischer Fehlerfall auf, d. h. erwärmt sich der Transistorchip 5 stark, sodass eine Volumenvergrößerung eines Bauteils eintritt, bspw. ein Teil des Transistorchips 5 verdampft, so wirkt im gezeigten Beispiel in positiver y-Richtung ein Druck auf den Träger 7. Gleichzeitig erweicht durch die Hitzeeinwirkung die Isolationsschicht 4, und der Druck hat ein Bewegen des Trägers 7 in positiver y-Richtung zu dem Rahmen 10 hin zur Folge. Da vorliegend das Material der Isolationsschicht 4 weicher ist als das Material des Trägers 7 und des Rahmens 10, nähern sich also die beiden Kurzschlussflächen 2, 3 aneinander an, bis Spitzen 12 der vorliegend pyramidenartigen Ausformungen 9 die zweite Kurzschlussfläche 3 berühren und somit elektrisch kontaktieren. Dieser Zustand der Kurzschlussvorrichtung 1 ist in der FIG 1 rechts, also in positiver x-Richtung, dargestellt.

Da die Oberflächenstruktur 8 und die zweite Kontaktfläche 3 im vorliegenden Beispiel aus unterschiedlichen Materialien bestehen, welche eine eutektische Legierung bilden, schmelzen die Spitzen 12 der Ausformungen 9 im gezeigten Beispiel bei einem Kontakt mit der zweiten Kontaktfläche 3 unter dem Einfluss der durch den thermischen Fehlerfall verursachten Hitze ein. Da es sich um eine eutektische Legierung handelt, erhärten die Kontaktpunkte jedoch unmittelbar nach dem Schmelzen und können erst bei einer erheblich höheren Temperatur wieder gelöst werden, wie sie vorliegend bei dem thermischen Fehlerfall nicht auftritt. Da der Rahmen 10 im gezeigten Beispiel mit dem Kollektor elektrisch verbunden ist und der Träger 7 elektrisch mit dem Emitter gekoppelt ist, ist somit über die Spitzen 12 eine sichere, vibrationsfeste und sehr gut leitfähige Kurzschließung von Kollektor und Emitter des Transistors erfolgt.

FIG 2 zeigt eine schematische Schnittdarstellung eines zweiten Ausführungsbeispiels einer Kurzschlussvorrichtung 1. Vorliegend ist der Transistorchip 5 an seiner Unterseite, also in negativer x-Richtung, mit einem Lot 13 auf einer Leiterstruktur 18 des Substrats 11 angebracht. An seiner Oberseite weist der Transistorchip 5 wieder, wie zuvor in FIG 1 gezeigt, eine Metallisierungsschicht 6 auf. In diesem Beispiel wird die erste Kurzschlussfläche 2 von der Oberseite dieser Metallisierungsschicht 6 selber gebildet. Entsprechend ist hier die Oberflächenstruktur 8 direkt auf der Metallisierungsschicht 6 angeordnet. Im gezeigten Beispiel wird die Oberflächenstruktur 8 mit den Ausformungen 9, welche wieder eine pyramidenartige Ausführung haben, in einem anderen Material als die Metallisierungsschicht 6 ausgeführt. Oberhalb der Oberflächenstruktur 8 erstreckt sich wie in FIG 1 gezeigt in einem Abstand der Rahmen 10 mit der zweiten Kurzschlussfläche 3, sowie zwischen Rahmen 10 und Oberflächenstruktur 8 die Isolationsschicht 4. In dem gezeigten Beispiel ist nun der Transistorchip 5 emitterseitig mit einem Bonddraht 15, welcher mit der Metallisierungsschicht 6 elektrisch gekoppelt ist an eine Leiterbahn 14 auf dem Substrat 11 elektrisch leitfähig verbunden. Der Bonddraht 15 kontaktiert dabei einen Bereich der Oberfläche der Metallisierungsschicht 6, in dem keine Oberflächenstruktur 8 auf der Metallisierungsschicht 6 angebracht ist. Von der Metallisierungsschicht 6 aus verläuft der Bonddraht 15 durch die Isolationsschicht 4 zunächst in positiver y-Richtung und dann seitlich in x-Richtung zu der Leiterbahn 14, welche in x-Richtung beabstandet von dem Transistorchip 5 auf dem Substrat 11 angeordnet ist. Dabei ist der Bonddraht 15 von dem Rahmen 10 isoliert.

Überhitzt sich nun der Transistorchip 5 und es kommt zu einem thermischen Fehlerfall, so wird durch die Explosion bzw. ggf. eine Ausdehnung die Metallisierungsschicht 6 mit den Ausformungen 9 an die zweite Kurzschlussfläche 3 gedrückt. Da gleichzeitig die Isolationsschicht 4 in Abhängigkeit der herrschenden Temperatur und des gewählten Materials der Isolationsschicht 4 wahlweise erweicht und/oder verdampft, wird der Rahmen 10, welcher wieder mit dem Kollektor des Transistors verbunden ist, mit der Metallisierungsschicht 6 und somit mit dem Emitter des Transistorchips 5 über die Ausformungen 9 kurzgeschlossen. Die Spitzen 12 der Ausformungen 9 bohren sich also durch die Isolationsschicht 4 zu dem Rahmen 10. Dabei sind die Spitzen 12 jedoch abgerundet, sodass eine elektrische Spitzenentladung vermieden wird. Die Kurzschlussvorrichtung 1 kann also auch für erprobte Transistoren, welche in einer Bonddrahttechnologie gefertigt sind, eingesetzt werden. Sie kann hier über zusätzliche Produktionsschritte in den bisherigen Produktionsablauf integriert werden.

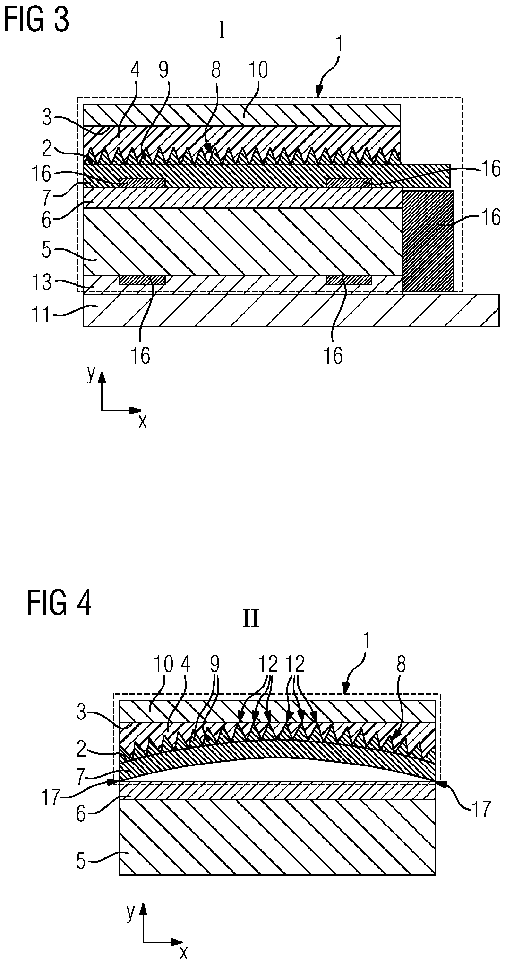

In FIG 3 ist eine schematische Schnittdarstellung eines dritten Ausführungsbeispiels einer Kurzschlussvorrichtung 1 dargestellt. Diese ist grundsätzlich wie das erste Ausführungsbeispiel in FIG 1 ausgeführt, weist jedoch zusätzlich Ausdehnungselemente 16 auf. Diese Ausdehnungselemente 16 sind im vorliegenden Beispiel an mehreren Stellen zwischen dem Substrat 11 und dem Träger 7 angeordnet. Im gezeigten Beispiel sind Ausdehnungselemente 16 zwischen der Metallisierungsschicht 6 an der Oberseite des Transistorchips 5 und dem Träger 7 mit der Oberflächenstruktur 8 angeordnet. Auch zwischen dem Transistorchip 5 und einem Lot 13 an der Unterseite des Transistorchips 5 sind vorliegend Ausdehnungselemente 16 angeordnet. Zusätzlich erstreckt sich im gezeigten Beispiel der Träger 7 in x-Richtung seitlich über den Transistorchip 5 nebst zugehöriger Metallisierungsschicht 6 und dem Lot 13 in x-Richtung hinaus. Parallel dazu erstreckt sich auch das Substrat 11 in gleicher Weise seitlich über den Transistorchip 5 hinaus. In der vorliegenden Ausführungsform ist nun zwischen dem Träger 7 und dem Substrat 11 bzw. zwischen den jeweiligen über den Transistorchip 5 hinausstehenden Bereichen derselben ein Ausdehnungselement 16 angeordnet, welches sich vorliegend in voller Höhe, also in voller Größe der Erstreckung in y-Richtung, von Transistorchip 5 nebst Metallisierungsschicht 6 und Lot 13 erstreckt.

Diese Ausdehnungselemente 16 verfügen über einen besonders großen, die sie umgebenen Bauteile übertreffenden thermischen Ausdehnungskoeffizienten. Erwärmt sich also der Transistorchip 5 im thermischen Fehlerfall übermäßig, so vergrößern auch die Ausdehnungselemente 16 ihr Volumen stärker als die sonstigen, insbesondere die die Ausdehnungselemente 16 umgebenden, Bauteile des Transistors. Dadurch wird der Träger 7 nach oben in positiver y-Richtung gedrückt, sodass wie oben bei FIG 1 erklärt die beiden Kurzschlussflächen 2, 3 in elektrischen Kontakt treten. Es kann hier über eine geeignete Wahl des Materials der Ausdehnungselemente 16 sogar eine spezifische Temperaturgrenze eingestellt werden, oberhalb derer sich bspw. die Ausdehnungselemente 16 schlagartig aufschäumen, wie es z.B. durch in die Ausdehnungselemente 16 eingeschlossene Gelkapseln, welche bei Überschreiten einer gewissen Temperatur verdampfen und somit schlagartig einen großen Druck generieren, erzielt werden kann. Die gewählte Temperatur, bei der dies geschieht, kann bspw. 300°C sein.

In FIG 4 ist eine schematische Schnittdarstellung eines vierten Ausführungsbeispiels einer Kurzschlussvorrichtung 1 zu sehen. Vorliegend ist das Ausführungsbeispiel in einem Kurzschlussbetrieb gezeigt. Über dem Transistorchip 5 nebst zugehöriger Metallisierungsschicht 6 erstreckt sich hier wieder ein Träger 7 mit der ersten Kurzschlussfläche 2, an welcher die Oberflächenstruktur 8 mit den Ausformungen 9 angeordnet ist. Im Gegensatz zu den anderen gezeigten Beispielen ist der Träger 7 jedoch vorliegend gewölbt, so dass er nur in zwei Randbereichen 17 die Metallisierungsschicht 6 des Transistorchips 5 berührt, zwischen den Randbereichen 17 jedoch von der Metallisierungsschicht 6 beabstandet ist. Da jedoch der Rahmen 10 mit der zugehörigen Kurzschlussfläche 3 nach wie vor eben ist und parallel zu der Oberfläche des Transistorchips 5 und der zugehörigen Metallisierungsschicht 6 verläuft, ist der Abstand zwischen dem Träger 7 und der zweiten Kurzschlussfläche 3 in dem Bereich zwischen den Randbereichen 17 verringert. Dies ist vorliegend so stark der Fall, dass die Spitzen 12 der Ausformungen 9 bereits mehrere elektrische Kontakte mit der zweiten Kurzschlussfläche gebildet haben. Der Träger 7, welcher bspw. emitterseitig mit dem Transistorchip 5 elektrisch verbunden ist und der Rahmen 10, welcher bspw. kollektorseitig mit dem Transistorchip 5 elektrisch verbunden ist, sind also vorliegend kurzgeschlossen.

In einem Normalbetrieb würde die gezeigte Ausführungsform der Kurzschlussvorrichtung 1 in der Schnittdarstellung jedoch nicht von dem in FIG 1 gezeigten Ausführungsbeispiel zu unterscheiden sein. Jedoch haben vorliegend aufgrund der Erwärmung spezifische Eigenschaften des Trägers 7, vorwiegend seine Eigenschaft als Bimetall, alternativ als eine Formgedächtnislegierung, dazu geführt, dass sich der Träger 7 bei der in dem thermischen Fehlerfall eintretenden Erhitzung wölbt. Alternativ zum gezeigten Beispiel kann das Bimetall bzw. die Formgedächtnislegierung, also der Träger, auch oberhalb, also in positiver y-Richtung über der Isolationsschicht realisiert sein, sodass sich dann das Bimetall bzw. die Formgedächtnislegierung nach unten wölben würde. Somit führt hier die Erhitzung zu einem Druck auf die Kurzschlussfläche 2, welcher die pyramidenartigen Ausformungen 9 durch die Isolationsschicht 4 hindurch auf die zweite Kurzschlussfläche 3 drückt. Da die Kurzschlussvorrichtung 1 nach dem Fehlerfall wieder in der Temperatur absinken kann, was beispielsweise ein Reduzieren der Krümmung des Trägers 7 nach sich ziehen kann, ist die Verwendung von unterschiedlichen Materialien, welche eine eutektische Legierung bilden, beispielsweise für zumindest die Spitzen 12 und den Rahmen 10 besonders vorteilhaft, da der elektrische Kontakt so mechanisch besonders belastbar ist.

Derselbe Effekt kann erreicht werden, wenn die Oberflächenstruktur 8 zum Durchstoßen der Isolierschicht 4 aus einem anderen Metall als die darunter liegende Metallisierungsschicht 6 realisiert wird, sodass die Oberflächenstruktur 8 eine von der Metallisierungsschicht 6 verschiedene thermische Ausdehnung aufweist. Insbesondere kann dann ggf. auf einen zusätzlichen Träger 7 verzichtet werden.

## Patentansprüche

1. Kurzschlussvorrichtung (1) zum automatischen Kurzschließen eines ersten Elements eines Transistors mit einem zweiten Element des Transistors in einem thermischen Fehlerfall des Transistors, mit
- einer ersten Kurzschlussfläche (2), welche mit dem ersten Element elektrisch gekoppelt ist,
- einer zweiten Kurzschlussfläche (3), welche mit dem zweiten Element elektrisch gekoppelt ist, und
- einer Isolationsschicht (4) zwischen den beiden Kurzschlussflächen,
wobei die beiden Kurzschlussflächen (2, 3) in einem Normalbetrieb (I) des Transistors vor dem Fehlerfall elektrisch voneinander isoliert sind und in einem auf den Fehlerfall folgenden Kurzschlussbetrieb (II) des Transistors elektrisch kurzgeschlossen sind,
**dadurch gekennzeichnet, dass**
in dem Normalbetrieb (I) des Transistors die beiden Kurzschlussflächen (2, 3) und die Isolationsschicht (4) druckfrei aneinander gehalten sind und darauf ausgelegt sind, dass erst im thermischen Fehlerfall des Transistors durch eine durch den thermischen Fehlerfall in dem Transistor verursachte Hitzeentwicklung , welche zu einer Volumenvergrößerung zumindest eines Bauteils und damit zu einem Druck auf zumindest eine der beiden Kurzschlussflächen (2, 3) führt, die Isolationsschicht (4) erweicht wird und somit die beiden Kurzschlussflächen (2, 3) gegeneinander gedrückt werden, wobei eine der beiden Kurzschlussflächen (2, 3) eine Oberflächenstruktur (8) hat, welche zumindest eine Ausformung (9) nach Art eines Durchstoßkörpers aufweist, um eine Durchstoßarbeit zu verringern, welche erforderlich ist, um bei einem Annähern der beiden Kurzschlussflächen (2, 3) im Fehlerfall die Isolationsschicht (4) zu durchstoßen und die beiden Kurzschlussflächen (2, 3) elektrisch kurz zu schließen.

2. Kurzschlussvorrichtung (1) nach Anspruch 1,
**dadurch gekennzeichnet, dass**
die zumindest eine Ausformung (9) die Form einer Säule oder Pyramide, in beiden Fällen insbesondere mit einer abgerundeten Spitze, oder einer Kugel hat.

3. Kurzschlussvorrichtung (1) nach einem der Ansprüche 1 bis 2,
**dadurch gekennzeichnet, dass**
die zumindest eine Ausformung (9) zumindest teilweise aus einem ersten Material und die andere Kurzschlussfläche (3, 2), welche nicht über die zumindest eine Ausformung (9) verfügt, zumindest teilweise aus einem zweiten Material gebildet ist, und das erste Material mit dem zweiten Material eine eutektische Legierung bildet.

4. Kurzschlussvorrichtung (1) nach einem der vorhergehenden Ansprüche,
**dadurch gekennzeichnet, dass**
die Isolationsschicht (4) ein keramisches Material und/oder einen Polymer und/oder ein Siloxan und/oder eine Kombination dieser Materialien enthält, insbesondere aus einem Material besteht, welches im Normalbetrieb (I) des Transistors fest ist und im thermischen Fehlerfall des Transistors erweicht und/oder seinen Aggregatszustand ändert, sodass das Material der Isolationsschicht (4) entweichen kann.

5. Kurzschlussvorrichtung (1) nach einem der vorhergehenden Ansprüche,
**dadurch gekennzeichnet, dass**
hinter der einen der beiden Kurzschlussflächen (2, 3), also auf der der jeweiligen anderen Kurzschlussfläche (3, 2) abgewandten Seite der einen Kurzschlussfläche (2, 3), ein Transistorchip (5) des Transistors angeordnet ist, der, insbesondere planar, mit einem Träger (7) der einen Kurzschlussfläche (2, 3) ankontaktiert ist, wobei hinter der einen Kurzschlussfläche (2, 3), insbesondere zwischen dem Transistorchip (5) und dem Träger (7), zumindest ein Ausdehnungselement (16) angeordnet ist mit einem thermischen Ausdehnungskoeffizienten, welcher größer ist als der Ausdehnungskoeffizient von das Ausdehnungselement (16) unmittelbar umgebenden Bauteilen, insbesondere des Trägers (7) und/oder des Transistorchips (5), sodass im thermischen Fehlerfall über ein Ausdehnen des Ausdehnungselements (16) die eine Kurzschlussfläche (2, 3) an die andere Kurzschlussfläche (3, 2) gedrückt wird.

6. Kurzschlussvorrichtung (1) nach einem der vorhergehenden Ansprüche,
**dadurch gekennzeichnet, dass**
eine der Kurzschlussflächen (2, 3) auf einem Träger (7) angeordnet ist, welcher ein Bimetall oder eine Formgedächtnislegierung umfasst, sodass im thermischen Fehlerfall die eine Kurzschlussfläche (2, 3) durch ein Biegen an die andere Kurzschlussfläche (3, 2) gedrückt wird.

7. Kurzschlussvorrichtung (1) nach einem der vorhergehenden Ansprüche,
**dadurch gekennzeichnet, dass**
das erste Element des Transistors ein Kollektor des Transistors und das zweite Element des Transistors ein Emitter des Transistors ist und/oder es sich bei dem Transistor um einen Bipolartransistor mit isolierter Gate-Elektrode (IGBT) handelt.

8. Verfahren zum automatischen Kurzschließen eines ersten Elements eines Transistors mit einem zweiten Element des Transistors in einem thermischen Fehlerfall des Transistors, mit
- einer ersten Kurzschlussfläche (2), welche mit dem ersten Element elektrisch gekoppelt ist,
- einer zweiten Kurzschlussfläche (3), welche mit dem zweiten Element elektrisch gekoppelt ist, und
- einer Isolationsschicht (4) zwischen den beiden Kurzschlussflächen,
wobei die beiden Kurzschlussflächen (2, 3) in einem auf den Fehlerfall folgenden Kurzschlussbetrieb (II) des Transistors elektrisch kurzgeschlossen werden,
**dadurch gekennzeichnet, dass**
in einem Normalbetrieb (I) des Transistors vor dem Fehlerfall die beiden Kurzschlussflächen (2, 3) und die Isolationsschicht (4) druckfrei aneinander gehalten werden und im Fehlerfall eine Kurzschlussfläche (2, 3) durch eine durch den thermischen Fehlerfall in dem Transistor verursachte Hitzeentwicklung, welche zu einer Volumenvergrößerung zumindest eines Bauteils und damit zu einem Druck auf zumindest eine der beiden Kurzschlussflächen (2,3) führt und welche die Isolationsschicht (4) erweicht, an die andere Kurzschlussfläche (3, 2) gedrückt wird, sodass die beiden Kurzschlussflächen (2, 3) aufgrund der Hitzeentwicklung elektrisch kurzgeschlossen werden, wobei eine der beiden Kurzschlussflächen (2,3) eine Oberflächenstruktur (8) hat, welche zumindest eine Ausformung (9) nach Art eines Durchstoßkörpers aufweist, um eine Durchstoßarbeit zu verringern, welche erforderlich ist, um beim Annähern der beiden Kurzschlussflächen (2,3) im Fehlerfall die Isolationsschicht (4) zu durchstoßen.

## Claims

1. Short-circuit apparatus (1) for automatically short-circuiting a first element of a transistor with a second element of the transistor in the event of a thermal fault of the transistor, comprising
- a first short-circuit area (2), which is electrically coupled to the first element,
- a second short-circuit area (3), which is electrically coupled to the second element, and
- an insulation layer (4) between the two short-circuit areas,
wherein the two short-circuit areas (2, 3) are electrically insulated from one another in a normal operation (I) of the transistor before the fault event and are electrically short-circuited in a short-circuit operation (II) of the transistor following the fault event,
**characterized in that**
in the normal operation (I) of the transistor the two short-circuit areas (2, 3) and the insulation layer (4) are held against one another in a manner free of pressure and are designed so that only in the event of a thermal fault of the transistor due to heat development in the transistor caused by the thermal fault event, which leads to an increase in volume of at least one component and therefore to a pressure on at least one of the two short-circuit areas (2, 3), the insulation layer (4) becomes softened and therefore the two short-circuit areas (2, 3) are pressed against one another, wherein one of the two short-circuit areas (2, 3) has a surface structure (8), which has at least one formation (9) in the manner of a penetration body in order to reduce penetration work, which is required in order to penetrate the insulation layer (4) and to electrically short-circuit the two short-circuit areas (2, 3) when the two short-circuit areas (2, 3) become closer in the event of a fault.

2. Short-circuit apparatus (1) according to Claim 1,
**characterized in that**
the at least one formation (9) has the shape of a column or pyramid, in both cases in particular having a rounded-off tip, or a sphere.

3. Short-circuit apparatus (1) according to one of Claims 1 to 2,
**characterized in that**
the at least one formation (9) is formed at least partly from a first material and the other short-circuit area (3, 2) not having the at least one formation (9) is formed at least partly from a second material, and the first material forms together with the second material a eutectic alloy.

4. Short-circuit apparatus (1) according to one of the preceding claims,
**characterized in that**
the insulation layer (4) contains a ceramic material and/or a polymer and/or a siloxane and/or a combination of these materials, in particular consists of a material that is solid in the normal operation (I) of the transistor and softened in the event of a thermal fault of the transistor and/or changes its aggregate state such that the material of the insulation layer (4) can soften.

5. Short-circuit apparatus (1) according to one of the preceding claims,
**characterized in that**
a transistor chip (5) of the transistor is arranged behind one of the two short-circuit areas (2, 3), that is to say on the side of one short-circuit area (2, 3) facing away from the respective other short-circuit area (3, 2), said transistor chip being contact-connected, in particular in a planar manner, to a carrier (7) of one short-circuit area (2, 3), wherein at least one expansion element (16) is arranged behind one short-circuit area (2, 3), in particular between the transistor chip (5) and the carrier (7), said expansion element having a coefficient of thermal expansion greater than the coefficient of expansion of components directly surrounding the expansion element (16), in particular of the carrier (7) and/or of the transistor chip (5), such that in the event of a thermal fault one short-circuit area (2, 3) is pressed against the other short-circuit area (3, 2) by means of expansion of the expansion element (16).

6. Short-circuit apparatus (1) according to one of the preceding claims,
**characterized in that**
one of the short-circuit areas (2, 3) is arranged on a carrier (7), which comprises a bimetal or a shape memory alloy, such that in the event of a thermal fault, one short-circuit area (2, 3) is pressed against the other short-circuit area (3, 2) by way of bending.

7. Short-circuit apparatus (1) according to one of the preceding claims,
**characterized in that**
the first element of the transistor is a collector of the transistor and the second element of the transistor is an emitter of the transistor and/or the transistor is an insulated-gate bipolar transistor (IGBT).

8. Method for automatically short-circuiting a first element of a transistor with a second element of the transistor in the event of a thermal fault of the transistor, comprising
- a first short-circuit area (2), which is electrically coupled to the first element,
- a second short-circuit area (3), which is electrically coupled to the second element, and
- an insulation layer (4) between the two short-circuit areas,
wherein the two short-circuit areas (2, 3) are electrically short-circuited in a short-circuit operation (II) of the transistor following the fault event,
**characterized in that**
in a normal operation (I) of the transistor before the fault event the two short-circuit areas (2, 3) and the insulation layer (4) are held against one another in a manner free of pressure and in the event of a fault one short-circuit area (2, 3) is pressed against the other short-circuit area (3, 2) due to heat development in the transistor caused by the thermal fault event, which leads to an increase in volume of at least one component and therefore to a pressure on at least one of the two short-circuit areas (2, 3) and which softens the insulation layer (4), such that the two short-circuit areas (2, 3) are electrically short-circuited on account of the heat development, wherein one of the two short-circuit areas (2, 3) has a surface structure (8), which has at least one formation (9) in the manner of a penetration body in order to reduce penetration work, which is required in order to penetrate the insulation layer (4) when the two short-circuit areas (2, 3) become closer in the event of a fault.

## Revendications

1. Dispositif de court-circuitage (1) de mise en court-circuit automatique d'un premier élément d'un transistor avec un second élément du transistor dans une défaillance thermique du transistor, comportant
- une première surface de court-circuitage (2) couplée électriquement au premier élément,
- une seconde surface de court-circuitage (3) couplée électriquement au second élément, et
- une couche isolante (4) entre les deux surfaces de court-circuitage,
dans lequel les deux surfaces de court-circuitage (2, 3) sont isolées électriquement l'une de l'autre lors d'un fonctionnement normal (I) du transistor avant la défaillance et court-circuitées électriquement dans un fonctionnement de court-circuitage (II) du transistor à la suite de la défaillance, **caractérisé en ce que**
lors du fonctionnement normal (I) du transistor, les deux surfaces de court-circuitage (2, 3) et la couche isolante (4) sont maintenues l'une contre l'autre sans pression et sont conçues de sorte que la couche isolante (4) est ramollie et les deux surfaces de court-circuitage (2, 3) sont ainsi pressées l'une contre l'autre seulement lors de la défaillance thermique du transistor par un développement de chaleur provoqué par la défaillance thermique dans le transistor, laquelle entraîne une augmentation de volume d'au moins un composant et donc une pression sur au moins l'une des deux surfaces de court-circuitage (2, 3), dans lequel l'une des deux des surfaces de court-circuitage (2, 3) a une structure de surface (8) ayant au moins une formation (9) à la manière d'un corps de perforation pour réduire une perforation, qui est nécessaire au cas où les deux surfaces de court-circuitage (2, 3) s'approchent lors de la défaillance pour percer la couche isolante (4) et pour court-circuiter électriquement les deux surfaces de court-circuitage (2, 3).

2. Dispositif de court-circuitage (1) selon la revendication 1, **caractérisé en ce que**
l'au moins une formation (9) a la forme d'un pilier ou d'une pyramide, dans les deux cas en particulier comportant une extrémité arrondie, ou une bille.

3. Dispositif de court-circuitage (1) selon l'une des revendications 1 à 2, **caractérisé en ce que**
l'au moins une formation (9) est au moins partiellement constituée d'un premier matériau et l'autre surface de court-circuitage (3, 2) qui ne comporte pas l'au moins une formation (9) est au moins partiellement formée d'un second matériau, et le premier matériau forme avec le second matériau un alliage eutectique.

4. Dispositif de court-circuitage (1) selon l'une des revendications précédentes,
**caractérisé en ce que**
la couche isolante (4) contient un matériau céramique et/ou un polymère et/ou un siloxane et/ou une combinaison de ces matériaux, constituée en particulier d'un matériau qui est solide en fonctionnement normal (I) du transistor et qui ramollit en cas de défaillance thermique du transistor et/ou modifie son état d'agrégation, de sorte que le matériau de la couche isolante (4) peut s'échapper.

5. Dispositif de court-circuitage (1) selon l'une des revendications précédentes,
**caractérisé en ce que**
derrière l'une des deux surfaces de court-circuitage (2, 3), c'est-à-dire du côté de la surface de court-circuitage (2, 3) opposée à l'autre surface de court-circuitage respective (3, 2) est disposée une puce de transistor (5) du transistor, qui est connectée, en particulier planairement à un support (7) de l'une surface de court-circuitage (2, 3),
dans lequel derrière l'une surface de court-circuitage (2, 3), en particulier entre la puce de transistor (5) et le support (7), au moins un élément de dilatation (16) est agencé avec un coefficient de dilatation thermique supérieur au coefficient de dilatation de l'élément de dilatation (16) entourant immédiatement des composants, en particulier du support (7) et/ou de la puce de transistor (5), de sorte qu'en cas de défaillance thermique en dilatant l'élément de dilatation (16), l'une des surfaces de court-circuitage (2, 3) est pressée vers l'autre surface de court-circuitage (3, 2).

6. Dispositif de court-circuitage (1) selon l'une des revendications précédentes,
**caractérisé en ce que**
l'une des surfaces de court-circuitage (2, 3) est disposée sur un support (7) qui comprend un bilame ou un alliage à mémoire de forme, de sorte qu'en cas de défaillance thermique, l'une des surfaces de court-circuitage (2, 3) est pressée par flexion contre l'autre surface de court-circuitage (3, 2).

7. Dispositif de court-circuitage (1) selon l'une des revendications précédentes,
**caractérisé en ce que**
le premier élément du transistor est un collecteur du transistor et le second élément est un émetteur du transistor et/ou le transistor est un transistor bipolaire à grille isolée (IGBT).

8. Procédé de mise en court-circuit automatique d'un premier élément d'un transistor avec un second élément du transistor en cas de défaillance thermique du transistor, comprenant
- une première surface de court-circuitage (2) couplée électriquement au premier élément,
- une seconde surface de court-circuitage (3) couplée électriquement au second élément, et
- une couche isolante (4) entre les deux surfaces de court-circuitage,
dans lequel les deux surfaces de court-circuitage (2, 3) sont électriquement court-circuitées lors d'une opération de court-circuitage (II) du transistor à la suite de la défaillance,
**caractérisé en ce que**
dans un fonctionnement normal (I) du transistor avant la défaillance, les deux surfaces de court-circuitage (2, 3) et la couche isolante (4) sont maintenues l'une contre l'autre sans pression et en cas de défaillance, une surface de court-circuitage (2, 3) provoquée par une défaillance thermique du transistor par le développement de chaleur qui entraîne une augmentation de volume d'au moins un composant et donc une pression sur au moins une des deux surfaces de court-circuitage (2, 3) et qui ramollit la couche isolante (4) est pressée contre l'autre surface de court-circuitage (3, 2), de sorte que les deux surfaces de court-circuitage (2, 3) sont électriquement court-circuitées en raison du développement de chaleur, dans lequel l'une des deux surfaces de court-circuitage (2, 3) présente une structure de surface (8) ayant au moins une formation (9) à la manière d'un corps de perforation pour réduire la perforation, laquelle est nécessaire pour percer la couche isolante (4) au cas où les deux surfaces de court-circuitage (2, 3) se rapprochent lors de la défaillance.
